# FASCICULE DE BREVET EUROPEEN

(11) **EP 2 140 742 B1**
(45) Date de publication et mention de la délivrance du brevet: **01.06.2011**
(21) Numéro de dépôt: 01927980.1
(22) Date de dépôt: 17.04.2001
(51) Int. Cl.: H05K 1/09, H01B 1/16

(54) **SUBSTRAT TRANSPARENT POURVU DE PISTES ELECTROCONDUCTRICES**
DURCHSICHTIGES SUBSTRAT MIT ELEKTRISCH LEITENDEN LEITERZÜGEN
TRANSPARENT SUBSTRATE PROVIDED WITH ELECTROCONDUCTIVE STRIPS

(30) Priorité: 14.04.2000 DE 10018902; 09.08.2000 DE 10038768; 16.11.2000 DE 10056777; 13.12.2000 FR 0016199
(43) Date de publication de la demande: 06.01.2010
(73) Titulaire: SAINT-GOBAIN GLASS FRANCE, 92400 Courbevoie (FR)
(72) Inventeur: HAHN, Dieter, 52331 Übach-Palenberg (DE); SWITALLA, Josef, 52531 Übach-Palenberg (DE); KUMMUTAT, Rainer, 52134 Herzogenrath (DE); BEYRLE, André, F-60170 Tracy-le-Val (FR); LEBAIL, Yannick, F-60150 Chevincourt (FR)
(74) Mandataire: Muller, René
(86) Numéro de dépôt international: PCT/FR2001/001175
(87) Numéro de publication internationale: WO 2001/080608

(56) Documents cités:
- EP-A- 0 527 352
- US-A- 3 830 651

## Description

L'invention se rapporte à un procédé de fabrication de pistes électroconductrices sur un substrat transparent, par sérigraphie d'une pâte électroconductrice.

Depuis plusieurs années déjà, il est connu de munir des substrats transparents, notamment des vitrages, de pistes conductrices qui peuvent servir d'éléments de chauffage ou d'éléments d'antenne ou d'alarme.

Ces pistes sont généralement obtenues par le procédé de sérigraphie utilisant une pâte renfermant des particules d'argent métalliques. Il est connu de EP-A-0 712 814 que la pâte a une teneur élevée en argent, c'est-à-dire de 60 à 90 % en poids par rapport aux matières solides. Par ailleurs, EP-A-0 079 854 décrit une pâte, apte à être déposée par sérigraphie sur du verre, qui comprend de 45 à 90 % en poids de particules d'argent métallique de taille inférieure à 1 µm.

Les pistes électroconductrices peuvent aussi être obtenues par d'autres procédés que la sérigraphie, par exemple en procédant à l'extrusion d'une pâte thermodurcissable conductrice directement sur le verre pour former des fils étroits (voir DE-A-1 796 310).

Les pistes électroconductrices que l'on obtient après cuisson (cuisson qui est généralement effectuée en même temps que le traitement des vitrages en vue du formage et/ou de la trempe) ont une résistance mécanique suffisante. De ce fait, on évite l'étape supplémentaire de galvanisation, délicate à mettre en oeuvre en raison des risques de pollution qui y sont associés.

Les vitrages comportant des pistes électroconductrices sont largement répandus dans le domaine de l'automobile. Ces pistes sont le plus souvent employées comme pistes chauffantes, notamment sur des lunettes arrières, mais elles peuvent aussi être placées sur le vitrage pour y assurer une fonction d'alarme et/ou d'antenne. Les documents précités ne donnent aucune indication en ce qui concerne la largeur des pistes électroconductrices ainsi réalisées. En pratique, les pistes électroconductrices sont formées industriellement par sérigraphie classique et elles ont, après cuisson, une largeur comprise entre 0,4 et 1,2 mm et une épaisseur qui varie en fonction de la puissance nominale de chauffe et de la résistance ohmique par unité de surface considérées.

Du fait des fonctions intéressantes apportées par ces pistes, leur nombre sur un même vitrage à tendance à s'accroître au cours des années ce qui peut poser des problèmes d'encombrement et de visibilité. Ainsi, lorsque les pistes sont situées dans le champ de vision du vitrage, elles sont nettement visibles de l'intérieur, ce qui peut gêner le conducteur, et accessoirement de l'extérieur, ce qui nuit à l'esthétique du véhicule.

Par ailleurs, il est déjà connu d'utiliser des pochoirs de sérigraphie pour former des motifs variés sur du verre (voir DE-A 32 31 382 et DE-A-35 06 891). On peut ainsi appliquer la pâte en couche plus épaisse et/ou plus large à certains endroits du verre en une seule étape, (sans impression multiple), par exemple pour former les barres collectrices (ou « bus bars ») du courant électrique des vitrages chauffants. De cette manière, il est possible d'ajuster au mieux la température sur l'ensemble de la surface vitrée, cette température ne devant pas excéder 50°C dans la zone des barres collectrices dans des conditions de température ambiante normales pour une puissance de chauffe allant jusqu'à 450 Watts. Les exemples figurant dans les demandes de brevet précitées sont réalisés sous une tension continue couramment employée pour les automobiles d'environ 11 à 14 Volts.

On connaît aussi des vitrages chauffants et des vitrages avec antenne dont les pistes conductrices sont constituées de fils fins en tungstène de quelques micromètres de diamètre. Ces fils sont ne sont présents que sur des vitrages feuilletés et ils sont noyés au sein de la matière adhésive constituant la feuille intermédiaire car autrement on ne peut pas les fixer directement sur le verre de manière sûre. Etant plus fins, ces fils sont par conséquent moins visibles que les pistes conductrices obtenues par sérigraphie.

Il existe un besoin de la part des constructeurs automobiles, notamment pour des véhicules de haut de gamme, de disposer de vitrages en verre de sécurité trempé ou feuilleté pourvus de pistes conductrices peu visibles à l'oeil nu.

Le but de la présente invention est de former des pistes conductrices sur un substrat transparent, qui, tout en étant plus étroites que les pistes connues, sont aptes à remplir la fonction de conduction électrique qui leur est dévolue.

Ce but est atteint par le procédé de l'invention selon la revendication 1, qui consiste à former des pistes électroconductrices à la, surface d'un substrat transparent, par l'application par sérigraphie d'une pâte électroconductrice formant un motif prédéterminé, et à soumettre lesdites pistes à une cuisson, ledit procédé étant entre autres caractérisé en ce que l'on utilise une pâte thixotrope ayant une teneur en argent supérieure à 35 % et dont de préférence au moins 98 % des particules qui la constituent ont une taille inférieure à 25 µm, et un tamis ayant au moins 90 fils par cm, la largeur de la plus étroite des pistes électroconductrices individuelles formées par impression étant inférieure ou égale à 0,3 mm.

Il s'avère important pour obtenir les pistes électoconductrices présentant la largeur requise de contrôler soigneusement tous les éléments du procédé selon l'invention. A cet égard, il convient de porter une attention toute particulière aux caractéristiques de la pâte, notamment la thixotropie et la taille des particules entrant dans sa constitution, et aux paramètres du tamis, notamment la taille des mailles, l'épaisseur de son revêtement et la largeur des ouvertures (en l'espèce des fentes) à prévoir dans ledit revêtement qui correspond directement à la largeur des pistes à imprimer par sérigraphie. Grâce à l'invention, on peut produire industriellement en série des vitrages munis d'un motif prédéterminé de pistes particulièrement fines et peu visibles à l'oeil nu.

L'ouverture des mailles mais aussi la dimension des ouvertures ou des fentes prévues dans le revêtement du tamis pour l'impression dudit motif sur la surface d'un vitrage ont une influence directe sur la largeur desdites pistes. Etant donné que la dimension des fentes correspond sensiblement à la largeur des pistes obtenues, il faut former des fentes extrêmement étroites (en règle générale de l'ordre de 0,25 mm ± 0,05) dans ledit revêtement qui est lui-même relativement peu épais. Néanmoins, la largeur d'une de ces fentes peut s'étendre sur plus qu'une seule maille du tamis.

On ne peut cependant pas exclure qu'il y ait d'autres possibilités de produire des pistes étroites avec un autre procédé utilisant une pâte moins thixotrope, un tamis moins fin (par exemple constitué d'environ 70 fils par cm), un revêtement du tamis moins ou plus épais, ....

Malgré l'étroitesse desdites pistes, que l'on peut à peine discerner, on obtient une puissance de chauffage comparable à celle des pistes ou des zones de chauffage sérigraphiées usuelles. Néanmoins, l'épaisseur des pistes, bien qu'augmentée, est maintenue dans des limites acceptables. Les pistes obtenues à l'aide du procédé décrit ici ont ainsi une épaisseur maximale sur la surface du verre, mesurée après cuisson, d'environ 35 µm, plus généralement de l'ordre de 15 à 25 µm, alors que l'épaisseur des pistes conventionnelles est de 12 µm environ. Cette épaisseur maximale plus importante peut être obtenue entre autres grâce aux pâtes hautement thixotropes utilisées selon l'invention qui possèdent la faculté de recouvrer très rapidement leur viscosité initiale après impression sur le verre.

Grâce au procédé selon l'invention, il est donc possible de réduire significativement la largeur ou les dimensions des pistes électroconductrices individuelles en appliquant, par impression, une pâte thixotrope contenant au moins 35 % en poids d'argent, présentant de bonnes propriétés d'écoulement pour un gradient de cisaillement élevé et renfermant de très petites particules, au moyen d'un tamis particulièrement fin, constitué de fils de matière connue en soi, disposés de telle sorte que l'ouverture de la maille est faible.

Il convient de préciser l'importance que revêt le caractère thixotrope de la pâte en vue de son application par sérigraphie. Lors de l'application, la contrainte de cisaillement subie par la pâte est suffisamment élevée pour provoquer une chute importante et brutale de la viscosité ce qui permet à la pâte de passer au travers des orifices du tamis et de se déposer sur le substrat en formant le motif des pistes. Des pâtes qui conviennent à cet effet sont définies par un rapport de la viscosité en l'absence de cisaillement (viscosité de départ) à la viscosité sous contrainte de cisaillement (dans les conditions de la sérigraphie) qui varie de 50 à 1000 voire davantage, par exemple jusqu'à 1300-1500. A titre de comparaison, ce rapport est compris entre 2 et 10 pour les pâtes de sérigraphie usuelles.

Il est également important qu'après le dépôt sur le substrat, la pâte retrouve une valeur de viscosité la plus proche possible de celle de départ en un temps très court (temps de recouvrance) mais aussi que cette valeur reste stable dans le temps. De cette manière, on évite les inconvénients liés au fluage de la pâte, en particulier une augmentation de la largeur et une diminution de l'épaisseur des pistes imprimées, inconvénients qui deviennent d'autant plus importants que l'épaisseur de pâte déposée est élevée. De manière générale, il convient de choisir une pâte dont le temps de recouvrance est inférieur à 1 seconde, de préférence de l'ordre de quelques dixièmes de seconde.

Avec une pâte moins thixotrope ou comprenant des particules plus grosses, il n'est possible d'obtenir les pistes conductrices ayant la largeur indiquée car la pâte ne peut pas passer au travers des ouvertures étroites du tamis. De plus, on ne peut pas non plus envisager de produire des pistes conductrices étroites avec une pâte dont le temps de recouvrement (ou le temps de la transition entre l'état quasiment fluide sous cisaillement et l'état normal, pratiquement solide) est trop élevé pour permettre que les pistes demeurent stables immédiatement après l'enlèvement du tamis.

Lorsque la teneur en argent de la pâte est supérieure à 50 %, les pistes dont la largeur est inférieure à 0,25 mm peuvent être utilisées en tant que pistes chauffantes, sans augmentation de la température à la puissance nominale admissible. Les pistes dont la teneur en argent est plus faible, par exemple de l'ordre de 35 %, sont plutôt utilisées en tant qu'alarme et/ou antenne.

L'usage combiné d'une pâte thixotrope constituée de particules de très faible taille et d'un tamis à maillage fin permet d'imprimer des pistes conductrices avec une excellente résolution. En outre, en augmentant la teneur en argent dans la pâte thixotrope, on peut réduire l'épaisseur finale des pistes.

Bien que particulièrement adapté aux pâtes à base d'argent, l'invention peut être étendue aux pâtes renfermant des particules métalliques aptes à répondre aux critères de conduction électrique requis, telles que des particules de cuivre ou d'or.

Les vitrages obtenus conformément au procédé de l'invention, bien qu'étant pourvus de pistes plus étroites, possèdent des propriétés de conduction électrique comparables à celles d'un vitrage muni de pistes obtenues par sérigraphie classique, toutes choses étant égales par ailleurs (nombre de pistes, distance entre les pistes, disposition, ...). Dans le cas de vitrages chauffants notamment, une puissance de chauffe similaire est atteinte avec le même nombre de pistes.

Le procédé selon l'invention permet, dans une large mesure, de s'affranchir des contraintes qui imposent de faire varier la section transversale des pistes en fonction de l'emplacement qu'elles occupent sur le vitrage. Une telle contrainte existe par exemple sur des vitrages de forme trapézoïdale où les pistes situées en partie haute sont plus courtes que celles de la partie basse, ce qui nécessite d'adapter la section des pistes afin de conserver une puissance de chauffe comparable sur toute la surface du verre. On retrouve cette contrainte avec des vitrages où une puissance de chauffe maximale est recherchée dans la zone correspondant au champ de vision du conducteur. Dans ce cas, les pistes conductrices ont une largeur plus importante au voisinage des bords latéraux qu'au centre du vitrage. En procédant dans les conditions de l'invention, on peut former des pistes de largeur identique sans que cela se traduise par une différence notable de l'uniformité de la puissance de chauffe. A cet égard, il y a tout lieu de penser que la diminution de la résistance électrique résulte du fait que la pâte a une teneur élevée en argent et qu'elle est déposée sur une plus grande épaisseur. Les valeurs de température maximale admissible au niveau des barres collectrices sont largement respectées sans qu'il y ait la nécessité d'appliquer une épaisseur importante de pâte de sérigraphie à conductivité élevée. Le plus souvent, la température à proximité des barres collectrices est de 15 % inférieure à la température maximale admise et ne dépasse pas 50°C, dans des conditions normales de température ambiante, pour une puissance nominale n'excédant pas 450 Watts pour une tension d'alimentation de 11 à 14 Volts.

La production à l'échelle industrielle des vitrages obtenus conformément au procédé de l'invention permet de réaliser une économie de la pâte de sérigraphie, en particulier lorsque cette dernière est riche en argent (teneur supérieure ou égale à 80 %). Ceci est vrai pour la réalisation des pistes chauffantes et plus encore lorsqu'il s'agit de pistes destinées à fonctionner en tant qu'alarme et/ou antenne.

Conformément à une première réalisation préférée, on utilise conjointement une pâte thixotrope ayant une teneur en argent supérieure à 35 %, de préférence 50 % et mieux encore 70 %, dont l'essentiel (au moins 98 %) des particules constitutives ont une dimension inférieure à 25 µm, de préférence 12 µm, et un tamis de sérigraphie comptant au moins 90 fils par cm et une épaisseur de revêtement d'au moins 30 µm, de préférence 50 à 100 µm. Cette manière de procéder permet de déposer sur le substrat, par impression, en un seul passage, une épaisseur de pâte de sérigraphie relativement importante comparativement aux épaisseurs que l'on obtient habituellement. Les dépôts ainsi obtenus présentent, après la cuisson, une épaisseur inférieure à 35 µm, plus généralement de l'ordre de 15 à 25 µm.

Le tamis employé dans le cadre de cette réalisation a une épaisseur de revêtement plus importante (plus de 30 µm) que celle des tamis à nombre de fils équivalent utilisées pour l'application visée (généralement inférieure à 10 µm). Ce tamis peut être obtenu par la technique photographique, connue en soi, qui consiste à recouvrir la surface du tamis d'une couche ou d'un film de résine photoréticulable et à opérer par projection d'une diapositive afin de reproduire le motif d'impression sur le tamis. Dans le cas présent, on utilise une résine photoréticulable présensibilisée qui est apte à former un revêtement suffisamment solide pour résister à l'action de la racle de sérigraphie, en un temps très court, de l'ordre de 150 secondes, voire moins. A titre de comparaison, avec une résine photoréticulable classique, il est nécessaire d'avoir un temps d'insolation élevé, de l'ordre de 5 à 6 minutes pour obtenir une réticulation dans toute l'épaisseur du revêtement. Par « résine photoréticulable présensibilisée », on entend ici une résine préréticulée qui comprend un ou plusieurs polymères de bas poids moléculaire aptes à réagir sous l'effet de la lumière pour former un réseau réticulé. La résine photoréticulable présensibilisée peut notamment être mise en oeuvre sous la forme d'une couche d'émulsion déposée directement sur le tamis ou d'un film supportant ladite résine, ce film étant humidifié avant d'être appliqué à la surface du tamis. En limitant la durée d'insolation, on peut ainsi prévenir les effet de la lumière parasite à proximité des bords du masque d'impression, lumière qui provoque une réticulation non souhaitée de la résine. Il en résulte une réduction de la dimension du motif impressionné par rapport à celui du masque, sur la face soumise à l'insolation ce qui se traduit lors de la sérigraphie, par une réduction de la quantité de pâte déposée sur le substrat et une moins bonne résolution dans l'impression des pistes.

Il est avantageux de choisir un tamis dont les bords correspondant aux motifs d'impression sont sensiblement parallèles dans l'épaisseur de sorte que l'ouverture dévolue au passage de la pâte reste sensiblement constante d'une face à l'autre du tamis. En tout état de cause, il est souhaitable que la variation de l'ouverture entre les deux faces du tamis, pour un même motif soit inférieure à 20 %, et de préférence 10 %. A titre de comparaison, avec la résine photoréticulable classique précédemment citée, le temps d'insolation élevé nécessaire à la réticulation ne permet pas d'obtenir l'ouverture désirée correspondant au motif d'impression (réduction de l'ouverture voire bouchage complet).

La nature de fils constituant le tamis n'est pas critique. De préférence, les fils sont en polyester et chaque fil est constitué d'un fil unique (monofilament) de diamètre compris entre 30 et 60 µm, de préférence 40 et 50 µm.

La racle qui permet de presser la pâte au travers du tamis de sérigraphie peut être une racle usuelle ayant une arête d'impression à angle droit, chanfreinée ou arrondie. L'usage de ce dernier type de racle permet d'obtenir une certaine augmentation de la tension du cisaillement d'où une réduction de la viscosité de la pâte lors du passage à travers le tamis. De préférence, la racle est constituée, d'une matière du type polymère, par exemple un polyuréthane, présentant une dureté Shore A comprise entre 65 et 85.

Grâce à l'invention, on peut obtenir des pistes conductrices ayant une résistance surfacique inférieure à 2,5 mOhm par carré pour une épaisseur de 10 µm après la cuisson, ce qui correspond à une résistivité inférieure à 2,5 µOhm.cm.

En outre, les pistes conductrices présentent une résistance à l'abrasion satisfaisante, même lorsque leur épaisseur est importante. On attribue cela à la densification plus importante des particules d'argent dans la pâte lors de la cuisson.

On décrit ci-après la fabrication d'un vitrage chauffant en vue d'une utilisation en tant que lunette arrière chauffante d'un véhicule automobile.

La pâte thixotrope de sérigraphie contient 80 % d'argent, 4 % de fritte de verre et 16 % d'un médium qui a pour fonction de faciliter l'application sur le substrat. Toutes les particules contenues dans la pâte ont une taille inférieure à 15 µm. Le rapport de la viscosité sans contrainte de cisaillement à la viscosité sous contrainte de cisaillement dans les conditions de la sérigraphie est égal à 200.

Le tamis est constitué d'un tissu 100 T commercialisé par SEFAR qui renferme 100 fils par cm, chaque fil étant constitué d'un seul fil en polyester ayant un diamètre de 40 µm, et présente une ouverture de maille égale à 58 µm. Le tamis est recouvert d'une couche d'émulsion photoréticulable présensibilisée de 80 µm d'épaisseur et le motif correspondant au masque d'impression est reproduit sur le tamis par la technique photographique (temps d'insolation : 150 secondes; puissance de la lame : 7000 W). Les bords du revêtement au niveau des motifs reproduisant les pistes sont parallèles ce qui signifie que l'ouverture pour le passage de la pâte est constante d'une face à l'autre du tamis.

On imprime le motif du tamis sur une feuille de verre au moyen d'une racle en polyuréthane à angle droit de dureté Shore A égale à 85. Avec une vitesse d'impression de 20 m/min et un hors-contact de 8 mm, on forme des pistes qui, après un cycle de cuisson (de la température ambiante à 650°C en 150 s) présentent une largeur de 0,2 à 0,22 mm et une épaisseur de 15 µm. Le vitrage muni des barres collectrices de courant possède les mêmes performances en terme de résistance et de puissance de chauffe qu'un vitrage possédant un nombre identique de pistes conductrices, disposées de la même manière, obtenues par sérigraphie classique (largeur supérieure à 0,5 mm).

On décrit ci-après la fabrication d'un vitrage chauffant selon une autre variante de l'invention, mais également en vue d'une utilisation en tant que lunette arrière chauffante d'un véhicule automobile.

Bien que les racles usuelles aient une arête d'impression à angle droit et pointu, avec lequel la pâte est imprimée à travers le tamis sur la surface placée sous celui-ci, il s'est avéré préférable pour réaliser l'invention d'utiliser une arête d'impression modifiée de la racle permettant un certain effet de coin. On n'a pas encore trouvé d'explication pour cet effet résultant d'un chanfrein ou d'un arrondi de ladite arête d'impression pour cette configuration spécifique, mais on peut supposer qu'il y a un effet réciproque avec la thixotropie -c'est-à-dire la chute de viscosité par augmentation de la contrainte de cisaillement exercée sur le médium thixotrope- de la pâte de sérigraphie.

La vitesse d'impression par la racle est légèrement réduite comparativement aux procédés usuels du fait de la nécessité de faire passer la pâte à travers des fentes ou des- ouvertures de sections considérablement réduites par rapport aux sections des revêtements de tamis connus. En outre le hors-contact du tamis (c'est à dire la distance entre le tamis librement tendu et le substrat à imprimer, ici le vitrage) est fixé à 10 mm.

Avec ces matières et dimensions, une résistivité inférieure à 2,5 µ *cm peut être obtenue après cuisson.

Comme pâte, on utilise le produit H 669 de la société DuPont, dont la viscosité est égale à 17 Pa.s (Pascal x sec). Elle ne contient que des particules de taille inférieure ou égale à 10 µm. Elle présente un rapport de la viscosité sans contrainte de cisaillement à la viscosité sous contrainte de cisaillement dans les conditions de la sérigraphie égal à 100.

Le tamis est constitué d'un tissu 95 T, commercialisé par SAATI S.p.A., Italie, qui renferme 95 fils par cm, chaque fil étant constitué d'un seul fil en polyester ayant un diamètre de 40 µm, et présente une ouverture de maille égale à 65 µm. Le tamis est recouvert d'une couche d'émulsion photoréticulable présensibilisée d'environ 16 µm d'épaisseur et le motif correspondant au masque d'impression est reproduit sur le tamis par la technique photographique. Les bords du revêtement au niveau des motifs reproduisant les pistes sont parallèles ce qui signifie que l'ouverture pour le passage de la pâte est constante d'une face à l'autre du tamis. Les fentes formées dans le revêtement ont une largeur la plus étroite de 250 µm environ.

On imprime le motif du tamis sur une feuille de verre au moyen d'une racle en polyuréthane dont le chant est pourvu d'un biseau à 45° sur 0,2 mm et a une dureté Shore A égale à 65. Avec une vitesse d'impression de 0,35 m/sec et un hors-contact de 10 mm, on forme des pistes qui, après un cycle de cuisson (de la température ambiante à 650°C en 150 s) présentent une largeur de 0,2 à 0,22 mm et une épaisseur de 12-15 µm. Le vitrage muni des barres collectrices de courant possède les mêmes performances en terme de résistance et de puissance de chauffe qu'un vitrage possédant un nombre identique de pistes conductrices, disposées de la même manière, obtenues par sérigraphie classique (largeur supérieure à 0,5 mm).

## Revendications

1. Procédé de fabrication de pistes électroconductrices sur un substrat transparent, selon lequel on applique, par sérigraphie, une pâte électroconductrice à la surface du substrat pour former un motif prédéterminé de pistes et on soumet lesdites pistes à une cuisson, **caractérisé en ce que** l'on utilise une pâte thixotrope possédant un rapport de la viscosité sans contrainte de cisaillement à la viscosité sous contrainte de cisaillement dans les conditions de la sérigraphie d'au moins 50 et ayant une teneur en argent supérieure à 35 %, et un tamis dont le revêtement est pourvu, au moins partiellement, de fentes dont la largeur la plus étroite est au plus égale à 0,25 mm ± 0,05 mm environ afin que la largeur de la plus petite des pistes électroconductrices formées par impression soit inférieure ou égale à 0,3 mm.

2. Procédé selon la revendication 1, **caractérisé en ce que** la pâte est constituée à 98 % de particules ayant une taille inférieure ou égale à 25 µm, et **en ce que** le tamis comprend au moins 90 fils par cm.

3. Procédé selon l'une des revendications 1 ou 2, **caractérisé en ce que** l'on utilise une pâte thixotrope ayant une teneur en argent supérieure à 50 %, de préférence 70 %, et dont au moins 98 % des particules ont une taille inférieure à 12 µm.

4. Procédé selon l'une des revendications 1 à 3, **caractérisé en ce que** l'on utilise un tamis ayant au moins 95 fils par cm et que l'on applique par impression des pistes conductrices individuelles dont la plus petite largeur est inférieure à 0,25 mm.

5. Procédé selon l'une des revendications 1 à 4, **caractérisé en ce que** l'on utilise un tamis pourvu d'un revêtement ayant une épaisseur supérieure ou égale à 10 µm.

6. Procédé selon la revendication 5, **caractérisé en ce que** l'épaisseur du revêtement du tamis est comprise entre 50 et 100 µm.

7. Procédé selon l'une des revendications 1 à 6, **caractérisé en ce que** le tamis est pourvu d'un revêtement dont les bords correspondant aux motifs d'impression sont sensiblement parallèles dans l'épaisseur.

8. Procédé selon l'une des revendications 1 à 7, **caractérisé en ce que** l'on utilise un tamis dont le revêtement est obtenu par insolation d'une résine photoréticulable présensibilisée.

9. Procédé selon la revendication 8, **caractérisé en ce que** la résine est déposée sous la forme d'une émulsion ou d'un film supportant ladite résine appliqué à la surface du tamis.

10. Procédé selon l'une des revendications 1 à 9, **caractérisé en ce que** l'on utilise une racle ayant une dureté Shore A de l'ordre de 65 à 85 et une arête d'impression à angle droit.

11. Procédé selon l'une des revendications 1 à 8, **caractérisé en ce que** l'on utilise une racle ayant une dureté Shore A de l'ordre de 65 à 85 et une arête d'impression chanfreinée à 45° ou arrondie.

12. Procédé selon l'une des revendications 1 à 10, **caractérisé en ce que** l'on utilise une pâte thixotrope ayant une teneur en argent supérieure ou égale à 80 % et que l'on forme des pistes conductrices individuelles dont la plus petite largeur est comprise entre 0,1 et 0,25 mm.

13. Procédé selon l'une des revendications 1 à 12 dans lequel on utilise un tamis d'impression comportant au moins 90 fils par cm, de préférence 95 fils par cm.

## Claims

1. A method of manufacturing electrically conducting tracks on a transparent substrate, according to which an electrically conducting paste is applied, by screen printing, to the surface of the substrate in order to form a predetermined pattern of tracks and said tracks are subjected to baking, **characterized in that** a thixotropic paste is used, having a ratio of the viscosity without shear stress to the viscosity under shear stress under screen-printing conditions of at least 50 and having a silver content greater than 35%, and a screen whose coating is provided, at least partially, with slots, the narrowest width of which is at the most equal to about 0.25 mm ± 0.05 mm so that the width of the smallest of the electrically conducting tracks formed by printing is less than or equal to 0.3 mm.

2. The method as claimed in Claim 1, **characterized in that** the paste consists of 98% of particles having a size less than or equal to 25 µm, and **in that** the screen comprises at least 90 threads per cm.

3. The method as claimed in either of Claims 1 and 2, **characterized in that** a thixotropic paste is used having a silver content greater than 50%, preferably 70%, and of which at least 98% of the particles have a size less than 12 µm.

4. The method as claimed in one of Claims 1 to 3, **characterized in that** a screen is used having at least 95 threads per cm and **in that** individual conducting tracks are applied by printing, the smallest width of which is less than 0.25 mm.

5. The method as claimed in one of Claims 1 to 4, **characterized in that** a screen is used provided with a coating having a thickness greater than or equal to 10 µm.

6. The method as claimed in Claim 5, **characterized in that** the thickness of the screen coating is between 50 and 100 µm.

7. The method as claimed in one of Claims 1 to 6, **characterized in that** the screen is provided with a coating, the edges of which corresponding to the printing patterns are substantially parallel within the thickness.

8. The method as claimed in one of Claims 1 to 7, **characterized in that** a screen is used, the coating of which is obtained by irradiation of a presensitized photocrosslinkable resin.

9. The method as claimed in Claim 8, **characterized in that** the resin is deposited in the form of an emulsion or of a film supporting said resin applied to the surface of the screen.

10. The method as claimed in one of Claims 1 to 9, **characterized in that** a doctor blade is used having a Shore A hardness of about 65 to 85 and a right-angled printing edge.

11. The method as claimed in one of Claims 1 to 8, **characterized in that** a doctor blade is used having a Shore A hardness of about 65 to 85 and a printing edge chamfered at 45° or rounded.

12. The method as claimed in one of Claims 1 to 10, **characterized in that** a thixotropic paste is used having a silver content greater than or equal to 80% and that individual conducting tracks are formed, the smallest width of which is between 0.1 and 0.25 mm.

13. The method as claimed in one of Claims 1 to 12, **characterized in that** a printing screen is used comprising at least 90 threads per cm, preferably 95 threads per cm.

## Patentansprüche

1. Verfahren zur Herstellung von elektrisch leitenden Bahnen auf einem transparenten Substrat, wonach mittels Siebdruck eine elektrisch leitende Paste auf die Oberfläche des Substrats aufgebracht wird, um ein vorbestimmtes Muster von Bahnen zu bilden, und die Bahnen einem Härten unterzogen werden, **dadurch gekennzeichnet, dass** eine thixotrope Paste verwendet wird, die ein Verhältnis der Viskosität ohne Scherbeanspruchung zur Viskosität unter Scherbeanspruchung unter den Bedingungen des Siebdrucks von wenigstens 50 aufweist und einen Silbergehalt von über 35 % hat, sowie ein Sieb, dessen Beschichtung wenigstens teilweise mit Schlitzen versehen ist, deren engste Breite höchstens gleich 0,25 mm ± etwa 0,05 mm beträgt, damit die Breite der kleinsten der durch Drucken gebildeten
elektrisch leitenden Bahnen kleiner als oder gleich 0,3 mm ist.

2. Verfahren nach Anspruch 1, **dadurch gekennzeichnet, dass** die Paste zu 98 % aus Partikeln mit einer Größe von weniger als oder gleich 25 µm besteht und dass das Sieb wenigstens 90 Fäden pro cm umfasst.

3. Verfahren nach einem der Ansprüche 1 oder 2, **dadurch gekennzeichnet, dass** eine thixotrope Paste verwendet wird, die einen Silbergehalt von mehr als 50 %, vorzugsweise 70 % aufweist und wovon wenigstens 98 % der Partikel eine Größe von weniger als 12 µm aufweisen.

4. Verfahren nach einem der Ansprüche 1 bis 3, **dadurch gekennzeichnet, dass** ein Sieb verwendet wird, das wenigstens 95 Fäden pro cm aufweist und dass einzelne Leiterbahnen aufgedruckt werden, deren kleinste Breite weniger als 0,25 mm beträgt.

5. Verfahren nach einem der Ansprüche 1 bis 4, **dadurch gekennzeichnet, dass** ein Sieb verwendet wird, das mit einer Beschichtung versehen ist, die eine Dicke von mehr als oder gleich 10 µm aufweist.

6. Verfahren nach Anspruch 5, **dadurch gekennzeichnet, dass** die Dicke der Beschichtung des Siebes im Bereich zwischen 50 und 100 µm liegt.

7. Verfahren nach einem der Ansprüche 1 bis 6, **dadurch** gekennzeiclenet, dass das Sieb mit einer Beschichtung versehen ist, deren den Druckmustern entsprechende Ränder in der Dicke im Wesentlichen parallel verlaufen.

8. Verfahren nach einem der Ansprüche 1 bis 7, **dadurch gekennzeichnet, dass** ein Sieb verwendet wird, dessen Beschichtung durch Sonnenbestrahlung eines lichtvernetzbaren, vorsensibilisierten Harzes erhalten wird.

9. Verfahren nach Anspruch 8, **dadurch gekennzeichnet, dass** das Harz in Form einer Emulsion oder eines auf die Oberfläche des Siebes aufgebrachten Films, der das Harz trägt, abgeschieden wird.

10. Verfahren nach einem der Ansprüche 1 bis 9, **dadurch gekennzeichnet, dass** eine Rakel verwendet wird, die eine Shore A-Härte in der Größenordnung zwischen 65 und 85 sowie eine rechtwinkelige Druckkante aufweist.

11. Verfahren nach einem der Ansprüche 1 bis 8, **dadurch gekennzeichnet, dass** eine Rakel verwendet wird, die eine Shore A-Härte in der Größenordnung zwischen 65 und 85 sowie eine unter 45° gefaste oder abgerundete Druckkante aufweist.

12. Verfahren nach einem der Ansprüche 1 bis 10, **dadurch gekennzeichnet, dass** eine thixotrope Paste verwendet wird, die einen Silbergehalt von mehr als oder gleich 80 % aufweist und dass einzelne Leiterbahnen gebildet werden, deren kleinste Breite zwischen 0,1 und 0,25 mm liegt.

13. Verfahren nach einem der Ansprüche 1 bis 12, **dadurch gekennzeichnet, dass** ein Drucksieb mit wenigstens 90 Fäden pro cm, vorzugsweise 95 Fäden pro cm verwendet wird.
